# EUROPEAN PATENT APPLICATION

(11) **EP 2 669 943 A1**
(43) Date of publication of application: **04.12.2013**
(21) Application number: 12305589.9
(22) Date of filing: 28.05.2012
(51) Int. Cl.: H01L 23/433

(54) **Methods and apparatus for providing transfer of a heat load between a heat source and a heat receiver**

(71) Applicant: Alcatel Lucent, 75007 Paris (FR)
(72) Inventor: Taheny, Oliver, Galway (IE); Hernon, Domhnaill, Dublin 15 (IE)
(74) Representative: Sayettat, Julien Christian

(57) **Abstract**

An apparatus for providing transfer of a heat load between a heat source and a heat receiver, said apparatus comprising:
a female part (1) configured to be fixed to said heat source or said heat receiver, said female part comprising a female structure (4); and
a male part (2) configured to be fixed to the other of said heat source or said heat receiver, said male part comprising a male structure (5);
wherein said male part and said female part are configured to form a heat transfer surface for said heat load therebetween when said male part is placed in said female part; and
wherein structures (4, 5) are configured to provide a heat transfer surface that increases with the temperature, so as to increase the heat load transfer between said structures.

## Description

### TECHNICAL FIELD

The invention relates generally to methods and apparatus for providing transfer of a heat load between a heat source and a heat receiver.

### BACKGROUND

In some known systems, heat sinks, such as copper heat sinks, may be connected to the heat generating component(s) of an electronic equipment, for example processors of an electronic circuit pack, in order to provide transfer of heat load from the heat generating component(s). In some of these systems, such heat sinks are connected directly to such a component by means of a thermal interface material which sits entirely on or within the circuit pack.

In some known systems, several electronic circuit packs equipped with such heat sinks may be put in a shelf designed cooling architecture comprising a number of fan trays, and air deflectors that are positioned respectively at the air inlet and the air exit of said architecture, so as to accommodate the positioning of said circuit packs in a hot aisle/cool aisle environment.

In some known systems, copper heat sinks comprising a base at which heat pipes are embedded can be used, said heat pipes allow the connection of said heat sinks to a heat generating component of a circuit pack. Moreover, the heat pipes allow reduction of the thermal resistance of the heat sink.

### SUMMARY

Some embodiments include a flexible cooling technology which enables notably the removal of heavy and expensive heat sinks from the electronic equipments, so as to improve the thermal conductivity, reduce the noise level or reduce the footprint of the heat sinks on the circuit pack.

In a first embodiment, an apparatus is provided for providing transfer of a heat load between a heat source and a heat receiver. The apparatus comprises:
a female part configured to be fixed to said heat source or said heat receiver, said female part comprising a female structure; and
a male part configured to be fixed to the other of said heat source or said heat receiver, said male part comprising a male structure;
wherein said male part and said female part are configured to form a heat transfer surface for said heat load therebetween when said male part is placed in said female part; and
wherein structures are configured to provide a heat transfer surface that increases with the temperature, so as to increase the heat load transfer between said structures.

In a second embodiment, a heat pipe is provided for thermally and mechanically connecting a heat source and a heat receiver. The heat pipe comprises two ends that are each equipped with respectively a part of such an apparatus.

### BRIEF DESCRIPTION OF THE DRAWINGS

Other aspects and advantages of the invention will become apparent in the following description made with reference to the appended figures, wherein:
- figure 1 represents schematically an apparatus according to an embodiment, the male part and the female part of said apparatus being connected respectively to an end of a heat pipe and to a heat source or a heat receiver;
- figure 2 represents schematically portions of the male and female structures of the apparatus of figure 1, the male portion being represented in longitudinal section and the female portion being represented in perspective;
- figure 3 represents schematically portions of male and female structures of an apparatus according to a second embodiment of the invention, the male portion being represented in longitudinal section and the female portion being represented in perspective;
- figure 4 represents schematically in longitudinal section portions of male and female structures of an apparatus according to a third embodiment;
- figure 5 represents schematically portions of male and female structures of an apparatus according to a fourth embodiment, the male portion being represented in longitudinal section and the female portion being represented in perspective.

### DETAILED DESCRIPTION OF ILLUSTRATIVE EMBODIMENTS

In relation to the figures, an apparatus for providing transfer of a heat load between a heat source and a heat receiver is described below.

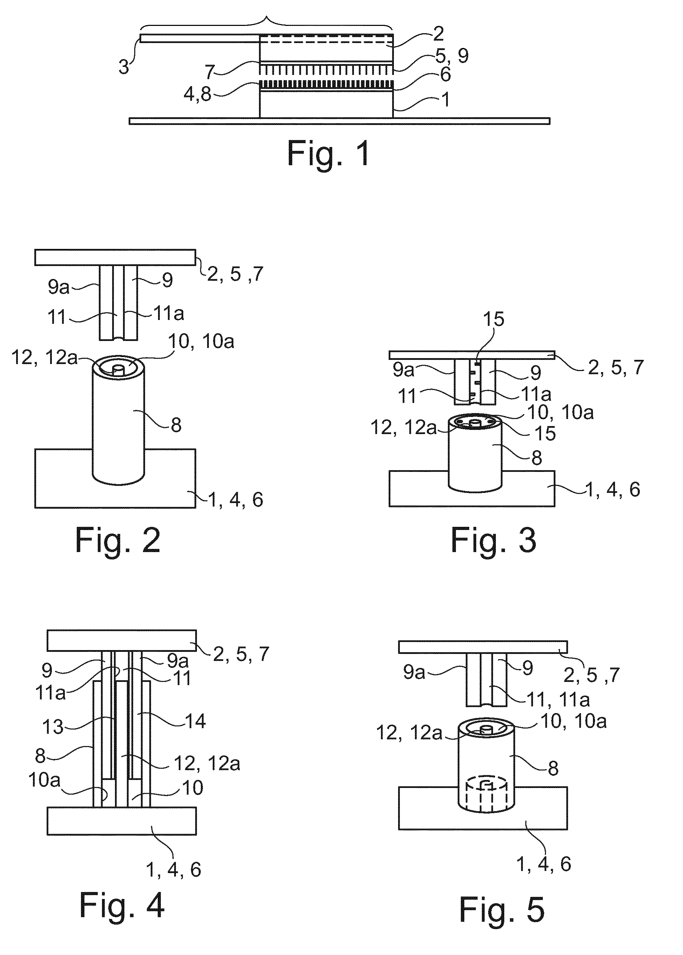

Referring to figures 1-5, the apparatus comprises a female part 1 configured to be fixed to the heat source or the heat receiver and a male part 2 configured to be fixed to the other of said heat source or said heat receiver, the parts 1, 2 further being configured to connect to each other.

The heat source can be notably a heat dissipating device of an electronic circuit pack, especially a high power dissipation device such as a processor. The heat receiver can be notably a cooling source which is external to said circuit pack, such as a thermal backplane.

For thermally and mechanically connecting the heat source and the heat receiver, a heat pipe 3 may be used, said heat pipe comprising two ends that are each equipped with respectively a part 1, 2 of the apparatus, so as to be connected to a heat source or a heat receiver which is equipped with the complementary part 1, 2 of the apparatus.

In particular, when connected to a heat source such as a processor of a circuit pack, the heat pipe 3 plays the role of an intermediate heat receiver. Similarly, when connected to a heat receiver such as a thermal backplane, the heat pipe 3 plays the role of an intermediate heat source, as it transfers to said heat receiver the heat load coming from the heat source.

In relation to figure 1, an end of the heat pipe 3 is equipped with the male part 2 of the apparatus, whereas the heat source or the heat receiver is equipped with the female part 1 of said apparatus. According to a non represented variant, the end of the heat pipe 3 can be equipped with the female part 1 of the apparatus, whereas the heat source or the heat receiver can be equipped with the male part 2 of said apparatus.

The female part 1 and the male part 2 comprise respectively a female structure 4 and a male structure 5. Moreover, the male part 2 and the female part 1 are configured to form a heat transfer surface for the heat load therebetween when said male part is place in said female part.

In relation to figure 1, the female structure 4 and the male structure 5 comprise each a base plate 6, 7 that supports a grid of respectively cylindrical female 8 and male 9 pins. The respective grids of structures 4, 5 present identical arrangements and their respective pins 8, 9 present complementary geometries in order to be interlocked and thus to form therebetween a heat transfer surface for a portion of the heat load.

The pins 8, 9 can be disposed in arrays, so that the number of said arrays and the number of pins 8, 9 in each of said arrays depend on the desired performances for the apparatus. For example, with larger numbers of arrays and larger numbers of pins 8, 9 in each array, the grids will be denser and provide greater heat transfer performances for the apparatus.

Moreover, the male 5 and female 4 structures may be configured to provide a heat transfer surface that increases with the temperature, so as to increase the heat load transfer between said structures. Thus, the apparatus is adapted to passively vary its thermal conductivity in function of the heat load that crosses said apparatus.

To do so, according to an embodiment, the male 5 and female 4 structures form a gap therebetween and comprise materials having different coefficients of thermal expansion, designed to enter into contact as the temperature increases in order to form the heat transfer surface.

In particular, each female pin 8 comprises a cylindrical housing 10 wherein a male pin 9 is configured to be placed. The diameter of the housing 10 is also slightly greater than the external diameter of the male pin 9, so that said male pin sits tightly into said female pin by forming a gap therebetween.

According to an embodiment, the coefficient of thermal expansion of the male structure 5 is greater than the coefficient of thermal expansion of the female structure 4. Moreover, the male structure 5 is arranged to expand radially as the temperature increases and comprises an external surface which is configured to face an internal surface of the female structure 4 with the gap therebetween.

In relation to figures 2 to 4, the external surface 9a of the male pin 9 faces the wall 10a of the housing 10 of the female pin 8, said wall defining the internal surface of said female pin. Moreover, the male pin 9 is arranged to expand radially so that its external surface 9a enters into contact with the internal surface 10a of the female pin 8 in order to form a heat transfer surface therebetween, the size of said heat transfer surface depending on the quantity of the heat load.

The male structure 5 can also comprise an internal surface that is smaller than its external surface and that is configured to face an external surface of the female structure 4 by forming a heat transfer surface therebetween. Moreover, a gap is formed between the surfaces upon radial expansion of the male structure 5.

To do so, in relation to figures 2 to 4, the male pin 9 comprises a cylindrical housing 11 whose wall 11a forms the internal surface of said pin and the female pin 8 comprises an internal pin 12 with an external surface 12a. Moreover, the internal pin 12 is arranged to be placed into the cylindrical housing 11 as the male pin 9 is placed into the female pin 8.

Thus, as the male pin 9 expands radially, the internal surface 11a of the male pin 9 deviates from the external surface 12a of the female pin 8, whereas the external surface 9a of said male pin enters into contact with the internal surface 10a of said female pin, so as to transfer radially the heat load crossing said pins through an increased heat transfer surface.

The male structure 5 may also comprise an internal layer 13 comprising a first material and an external layer 14 comprising a second material, wherein the coefficient of thermal expansion of the first material is different than the coefficient of thermal expansion of the second material. As represented on figure 4, the male pin 9 presents a bimetallic strip configuration and comprises two layers 13, 14 comprising materials, such as metal, that present different coefficients of thermal expansion.

Thus, when the temperature increases, the two layers 13, 14 expand radially at different rates, so that the male pin 9 expands radially to form a heat transfer surface with the female pin 8.

For improving the heat load transfer, at least one structure 4, 5 can also comprise surface features that are arranged to enter into contact with the other structure 4, 5 upon thermal expansion of structures 4, 5.

To do so, in relation to figure 3, the male pin 9 comprises protrusions 15 on his internal surface 11a and the female pin 8 comprises such protrusions 15 on his internal surface 10a. Upon thermal expansion of the male pin 9, the protrusions 15 of the male pin 9 expands into the external surface 12a of the female pin 8, whereas the external surface 9a of the male pin 9 enters into contact with the protrusions 15 of the female pin 8, so as to transfer the heat load therebetween.

In a variant not shown, the male pin 9 can comprise both two layers 13, 14 comprising different materials and surfaces features 15 for improving the heat load transfer.

Moreover, the surface features 15 can be of different lengths or shapes so as to allow varying thermal transfers between the male 9 and female 8 pins, said transfers varying with the heat loads from the electronic components.

According to another embodiment, the gap formed betweeb the male structure 5 and the female structure 4 may be partially filled with a thermally conductive fluid.

In relation to figure 5, the housing 10 of the female pin 8 is partially filled with a thermally conductive fluid, as indicated in dotted lines. The thermally conductive fluid may be notably a dielectric fluid, because it would be safe for electronic circuit packs and for the users of said circuit packs.

As the temperature increases, the fluid is forced to expand into the gap, so as to form an increased heat transfer surface between the male 9 and female 8 pins by contacting greater areas of the surfaces 9a, 10a, 11a, 12a of said pins.

In particular, the male 9 and female 8 pins can further comprise materials that present different coefficients of expansion, so that the coefficient of thermal expansion of the male pin 9 is greater than the coefficient of thermal expansion of the female pin 8. Thus, as the male pin 9 expands into the female pin 8, the gap therebetween decreases and the fluid is forced to expand in said decreasing gap.

Thus, the heat load transfer between the male structure 5 and the female structure 4 may be improved, since fluids are generally more thermally conductive than air. Moreover, a fluid may easily fill the gap between the male structure 5 and the female structure 4 regardless of the micro-surface roughness or the waviness of the gap that is formed therebetween.

However, as the male 2 and female 1 parts of the apparatus are removably connectable, the fluid must be sealed when said parts are disconnected, so as to avoid any leakage of fluid from said apparatus. To do so, the conductive fluid may be maintained into a structure 4, 5 of the connector by means of a sealing mechanism when the parts 1, 2 of said connector are disconnected.

In the embodiment represented on figure 5, the female pin 8 can comprise a mechanism that automatically seals said female pin upon removal of the male pin 9 from the housing 10 of said female pin, so as to reduce or eliminate leakage of conductive fluid from said female pin.

Moreover, the female structure 4 that comprises the fluid acts as a natural well and may be installed so that the gravity works against said fluid. Thus, the leakages of fluid can be minimized.

Advantageously, the apparatus allows a low-cost, removable and reliable thermal connection between a heat source and a heat receiver, as well as allowing removal of the heat load from a heat source without requiring heavy, cumbersome and expensive components to said heat source.

Advantageously, the apparatus may allow an enterprise to significantly reduce its Operational Expenditures (OPEX) or its Capital Expenditures (CAPEX) for cooling its electronic equipments, as for example equipments according to the ATCA standard or any other types of such equipments.

Furthermore, the apparatus may release significant portions of electronic real estate that was previously encumbered by heat sinks. Thus, the released portions may be used for adding more components and enhancing the product functionality of the electronic real estate.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to assist the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An apparatus for providing a transfer of a heat load between a heat source and a heat receiver, said apparatus comprising:
a female part (1) configured to be fixed to said heat source or said heat receiver, said female part comprising a female structure (4); and
a male part (2) configured to be fixed to the other of said heat source or said heat receiver, said male part comprising a male structure (5);
wherein said male part and said female part are configured to form a heat transfer surface for said heat load therebetween when said male part is placed in said female part; and
wherein structures (4, 5) are configured to provide a heat transfer surface that increases with the temperature, so as to increase the heat load transfer between said structures.

2. The apparatus of claim 1, wherein the male (5) and female (4) structures form a gap therebetween and comprise materials having different coefficients of thermal expansion.

3. The apparatus of claim 2, wherein the coefficient of thermal expansion of the male structure (5) is greater than the coefficient of thermal expansion of the female structure (4).

4. The apparatus of claim 3, wherein the male structure (5) is arranged to expand radially as the temperature increases and comprises an external surface (9a) which is configured to face an internal surface (10a) of the female structure (4) with the gap therebetween.

5. The apparatus of claim 4, wherein the male structure (5) comprises an internal surface (11a) that is smaller than its external surface (9a) and that is configured to face an external surface (12a) of the female structure (4) by forming a heat transfer surface therebetween, the gap being formed between said surfaces upon radial expansion of the male structure (5).

6. The apparatus according to any of claims 2 to 5, wherein the male structure (5) comprises an internal layer (13) comprising a first material and an external layer (14) comprising a second material, wherein the coefficient of thermal expansion of the first material is different than the coefficient of thermal expansion of the second material.

7. The apparatus according to any of claims 2 to 6, wherein at least one structure (4, 5) comprises surface features (15) that are configured to enter into contact with the other structure (4, 5) upon thermal expansion of structures (4, 5).

8. The apparatus according to claim 7, wherein the surface features (15) comprise protrusions.

9. The apparatus according to any of claims 2 to 8, wherein the gap formed between the male structure (5) and the female structure (4) is partially filled with a thermally conductive fluid.

10. The apparatus according to claim 9, wherein the thermally conductive fluid is maintained into a structure (4, 5) by means of a sealing mechanism when the male (5) and female (4) structures are disconnected.

11. The apparatus according to claim 9 or 10, wherein the thermally conductive fluid is a dielectric fluid.

12. A Heat pipe (3) for thermally and mechanically connecting a heat source and a heat receiver, said heat pipe comprising two ends that are each equipped with respectively a part (1, 2) of an apparatus according to any of claims 1 to 11.
